# DEMANDE DE BREVET EUROPEEN

(11) **EP 4 739 061 A1**
(43) Date de publication de la demande: **06.05.2026**
(21) Numéro de dépôt: 25210304.9
(22) Date de dépôt: 22.10.2025
(51) Int. Cl.: H10P 54/00, H10W 70/652, H10W 72/20, H10W 72/00, H10W 72/29, H10W 72/90

(54) **PROCÉDÉ DE FABRICATION D'UN CIRCUIT INTÉGRÉ MONOLITHIQUE, PAR EXEMPLE À BASE DE NITRURE DE GALLIUM, ET CIRCUIT INTÉGRÉ CORRESPONDANT**

(30) Priorité: 31.10.2024 FR 2411941
(71) Demandeur: STMicroelectronics International N.V., 1228 Plan-les-Ouates, Geneva (CH)
(72) Inventeur: VOLANT, Valerie, 38170 Seyssinet-Pariset (FR); COTTIN, Denis, 38920 CROLLES (FR); ARNO, Patrik, 38360 SASSENAGE (FR)
(74) Mandataire: Casalonga

(57) **Abrégé**

Procédé de fabrication d'un circuit intégré monolithique, comprenant une réalisation de blocs fonctionnels (BF1, BF2) au sein et au-dessus d'au moins un matériau semiconducteur large bande disposé sur un substrat de silicium, une réalisation de parties d'interconnexion mutuellement séparées (BEOL1, BEOL2) au-dessus des blocs fonctionnels, une séparation des blocs fonctionnels, et une réalisation d'une liaison électriquement conductrice entre le substrat et une plage de contact située sur une face supérieure de la partie d'interconnexion associée à un bloc fonctionnel. La séparation (C2) des blocs fonctionnels et la réalisation (C1) de ladite liaison électriquement conductrice sont effectuées après la réalisation des parties d'interconnexion mutuellement séparées.

## Description

Des modes de réalisation et de mise en œuvre concernent les circuits intégrés, notamment les circuits intégrés monolithiques et en particulier ceux incorporant des blocs fonctionnels réalisés sur des matériaux semiconducteurs à large bande interdite reposant sur un substrat de silicium, par exemple des matériaux tels le nitrure de gallium (GaN) et ses alliages, ou bien le carbure de silicium (SiC) et ses alliages, sans que ces exemples de matériau ne soient exhaustifs et limitatifs.

De tels blocs fonctionnels peuvent ensemble former par exemple un dispositif électronique.

Lorsque le nitrure de gallium (GaN) et ses alliages sont utilisés dans un tel dispositif, on parlera plus simplement de dispositif GaN. Lorsque le carbure de silicium (SiC) et ses alliages sont utilisés dans un tel dispositif, on parlera plus simplement de dispositif SiC.

Parmi ces dispositifs électroniques, on peut citer un dispositif d'alimentation à découpage (« DC-DC converter » en langue anglaise).

Dans un dispositif d'alimentation à découpage, les blocs fonctionnels peuvent comprendre : des transistors, généralement des transistors à haute mobilité électronique (transistors HEMT : High Electron Mobility Transistor), des pilotes (« drivers »), etc...

Certains de ces transistor HEMT sont des transistors dits « côté haut » (HS : High Side), c'est-à-dire connectés entre la charge et la tension d'alimentation. D'autres de ces transistors HEMT sont des transistors dits « côté bas » (LS : Low Side), c'est-à-dire connectés entre la charge et la masse.

Plusieurs possibilités d'intégration existent pour combiner différents blocs fonctionnels de façon à former des dispositifs GaN ou des dispositifs SiC.

On peut citer à cet égard une intégration discrète dans laquelle plusieurs composants discrets sont insérés dans un boîtier. On peut également citer l'intégration monolithique dans laquelle les fonctions d'alimentation, de pilotage, etc.., sont conçues dans la même puce.

En outre, la technologie dite WL-CSP (WaferLevel Chip Scale Packaging), dans laquelle la puce n'est pas encapsulée dans un boîtier, est très intéressante en raison de son faible encombrement et des faibles connexions électriques, réduisant ainsi les inductances parasites, le bruit et les pertes.

La tendance du marché des produits à base de matériaux à large bande interdite, par exemple les matériaux à base de nitrure de gallium, s'oriente vers des boîtiers de plus en plus petits avec des performances élevées tels que de forts courants de sortie, de faibles pertes, une efficacité de consommation, ce qui amène à résoudre de nombreux problèmes.

Un premier problème à résoudre réside dans la séparation physique des couches de matériaux à large bande interdite.

En effet, les composants de puissance à base de nitrure de gallium par exemple sont basés sur une structuration de couches de nitrure de gallium déposées sur toute la plaquette de silicium.

Or, lorsque des transistors HS et LS ainsi que des pilotes additionnels sont combinés sur une même puce monolithique, ces blocs fonctionnels nécessitent d'être physiquement séparés sans aucun lien entre les parties à basse et haute tension (LS et HS) et entre les transistors HS et LS et les pilotes.

Cette séparation physique est nécessaire pour éviter les fuites ainsi que l'atteinte de tensions de claquage.

Un deuxième problème à résoudre résulte dans la polarisation du substrat de silicium.

En effet, lorsque le dispositif électronique est intégré dans un système, le substrat de silicium doit être connecté à la masse ou être polarisé pour obtenir un comportement acceptable du dispositif en évitant autant que possible les problèmes de perte et de bruit nuisant aux performances du dispositif.

A cet égard, le substrat de silicium doit être polarisé, par exemple connecté à la masse, et ne peut pas être laissé flottant car la tension de seuil des dispositifs de puissance GaN dépendent de la polarisation du substrat de silicium.

Un troisième problème réside dans la longueur des interconnexions électriques.

En effet, les interconnexions électriques à l'intérieur du dispositif doivent être réduites le plus possible, pour éviter les inductances parasites responsables des surtensions durant la commutation des transistors de puissance ainsi que les interférences parasites du type électromagnétique.

Un quatrième problème réside dans l'encombrement surfacique du dispositif qui doit être le plus faible possible.

Le premier problème et le deuxième problème mentionnés ci-avant sont résolus ou n'existent pas avec une intégration à base de composant discrets.

Cependant, le troisième problème et le quatrième problème mentionnés ci-avant restent alors difficiles à résoudre.

C'est la raison pour laquelle il est particulièrement avantageux de s'orienter vers des solutions utilisant des composants monolithiques, c'est-à-dire des composants dans lesquels tous les blocs fonctionnels sont réalisés au sein d'une seule et même puce.

Ceci permet de résoudre le troisième et le quatrième problème mentionnés ci-avant.

Cependant, pour toutes ces solutions monolithiques, le premier problème et le deuxième problème mentionnés ci-avant nécessitent d'être résolus au niveau de la puce car les couches de matériaux à large bande interdite recouvrent toute la surface de la puce.

La fabrication d'un circuit intégré monolithique comportant des couches de matériaux à large bande interdite, par exemple des couches de matériaux contenant du nitrure de gallium, comportent plusieurs étapes.

Toutes ces étapes sont réalisées sur une plaquette (« *wafer* ») de silicium comportant des lignes de découpe permettant, *in fine,* après découpe de la plaquette selon ces lignes de découpe, d'obtenir tous les circuits intégrés individuels qui ont été réalisés simultanément dans les emplacements délimités par ces lignes de découpe.

Globalement, dans une première phase, on forme tout d'abord sur la plaquette de silicium l'empilement de couches de matériaux à large bande interdite, puis on réalise les différents composants et blocs fonctionnels comportant notamment des transistors, des pilotes, etc...

On procède ensuite, dans cette première phase, à la réalisation au-dessus de ces composants, de parties d'interconnexion connues par l'homme du métier sous l'acronyme anglosaxon BEOL (*Back End Of Line*) comportant des niveaux de métal et des niveaux de vias entre ces niveaux de métal, tous ces niveaux étant enrobés dans un matériau diélectrique.

Le dernier niveau de métal est classiquement recouvert d'une couche de passivation, par exemple en nitrure de silicium, comportant des ouvertures délimitant sur le dernier niveau de métal des plages de contact (« *pads* »).

Puis, dans une deuxième phase de fabrication, on forme, sur ces plages de contact, des billes de connexion destinées à être ultérieurement soudées sur une carte de circuit imprimé.

Actuellement, la séparation physique des blocs fonctionnels et de leur partie d'interconnexion respective, ainsi que la polarisation du substrat de silicium, sont effectuées par des étapes spécifiques au sein de cette première phase de fabrication des circuits intégrés.

Or, ces étapes spécifiques sont industriellement complexes à mettre en œuvre.

Il existe donc un besoin de réaliser cette séparation physique ainsi que la polarisation du substrat de silicium de façon plus simple et industriellement aisée à mettre en œuvre.

Les inventeurs ont observé à cet égard qu'il était possible de réaliser ces étapes de séparation et de polarisation dans la deuxième phase de réalisation des circuits intégrés avant la formation des billes de connexion.

Ceci permet une industrialisation plus flexible à un coût plus faible.

Selon un aspect, il est proposé un procédé de fabrication d'un circuit intégré monolithique.

Le procédé comprend une réalisation de blocs fonctionnels, par exemple mais de façon ni exhaustive ni limitative, des transistors HEMT HS et LS, des pilotes (« drivers »), etc..., au sein et au-dessus d'au moins un matériau semiconducteur large bande, par exemple un empilement de couches d'un tel matériau et de ses alliages, disposé sur un substrat de silicium.

Le procédé comprend également
- une réalisation de parties d'interconnexion (connue par l'homme du métier sous l'acronyme anglosaxon BEOL) mutuellement séparées au-dessus des blocs fonctionnels, et
- une réalisation d'une liaison électriquement conductrice entre le substrat et une plage de contact située sur une face supérieure d'une partie d'interconnexion.

Dans le procédé selon cet aspect, la séparation des blocs fonctionnels et la réalisation de ladite liaison électriquement conductrice sont effectuées après la réalisation des parties d'interconnexion mutuellement séparées.

En ce qui concerne le circuit intégré monolithique proprement dit, l'homme du métier sait qu'à l'issue de la réalisation de chaque partie d'interconnexion, le dernier niveau de métal est partiellement recouvert d'une couche de passivation, typiquement une couche de nitrure de silicium, formant une face supérieure de la partie d'interconnexion correspondante et possédant des ouvertures délimitant des plages de contact sur le dernier niveau de métal.

Aussi le fait de réaliser la séparation des blocs fonctionnels et ladite liaison électriquement conductrice après la réalisation des parties d'interconnexion, conduit à l'obtention dans le circuit intégré de tranchées dépourvues de couche de passivation, mais aussi d'une couche métallique prolongeant le dernier niveau de métal, comme c'est le cas dans les procédés selon l'art antérieur.

Selon un mode de mise en œuvre du procédé, ladite réalisation de la liaison électriquement conductrice comprend
- une réalisation d'une première tranchée profonde située à côté de ladite plage de contact et s'étendant depuis la face supérieure de ladite partie d'interconnexion jusqu'au substrat, et
- une formation d'une couche électriquement conductrice, typiquement une couche de redistribution comportant par exemple du cuivre, tapissant le fond de la première tranchée au contact du substrat ainsi que la paroi latérale de cette première tranchée et s'étendant sur la face supérieure de ladite partie d'interconnexion jusqu'à ladite plage de contact.

Selon un mode de mise en œuvre, la réalisation de deux parties d'interconnexion séparées, au-dessus de deux blocs fonctionnels adjacents, comporte une réalisation d'une tranchée initiale entre les deux parties d'interconnexion, et ladite séparation comporte :
- une réalisation d'une tranchée supplémentaire située entre les deux blocs fonctionnels adjacents, prolongeant ladite tranchée initiale et s'étendant jusqu'au substrat en traversant ledit au moins un matériau semiconducteur large bande, la tranchée initiale et la tranchée supplémentaire formant une deuxième tranchée profonde, et
- une formation d'une couche électriquement isolante, typiquement une couche de polyimide, située au-dessus de la paroi latérale et du fond de la deuxième tranchée.

Selon un mode de mise en œuvre :
- la couche électriquement conductrice (typiquement la couche de redistribution) est formée sur les parois de la première tranchée et de la deuxième tranchée et sur la face supérieure des deux parties d'interconnexion, puis
- une première partie de cette couche électriquement conductrice est retirée de la deuxième tranchée de façon à découvrir une partie du fond et de la paroi latérale de cette deuxième tranchée et à laisser subsister une deuxième partie de la couche électriquement conductrice sur le reste du fond et de la paroi latérale de cette deuxième tranchée, puis
- la couche électriquement isolante (typiquement la couche de polyimide) est formée de façon à recouvrir la couche électriquement conductrice à l'exception des zones situées au-dessus des plages de contact et à recouvrir la partie découverte du fond et de la paroi latérale de la deuxième tranchée.

Le procédé comprend en outre, selon un mode de mise en œuvre, une formation de billes de connexion au-dessus des portions de la couche électriquement conductrice (typiquement la couche de redistribution) situées au-dessus des plages de contact.

Selon un mode de mise en œuvre préféré, dans lequel le circuit intégré est fabriqué simultanément à d'autres circuits intégrés sur une plaquette semiconductrice au sein d'emplacements séparés par des lignes de découpe, préalablement au sciage de la plaquette le long des lignes de découpe, on réalise le long de ces lignes de découpes et simultanément à la réalisation des première et deuxième tranchées, des tranchées de séparation s'étendant jusqu'au substrat en traversant ledit au moins un matériau semiconducteur large bande.

Ledit au moins un matériau semiconducteur large bande peut être choisi dans le groupe formé par le nitrure de gallium (GaN) et ses alliages et le carbure de silicium (SiC) et ses alliages.

Selon un autre aspect, il est proposé un circuit intégré monolithique, comprenant
- plusieurs blocs fonctionnels au sein et au-dessus d'au moins un matériau semiconducteur large bande disposé sur un substrat de silicium,
- une partie d'interconnexion au-dessus de chaque bloc fonctionnel comportant plusieurs niveau de métal, le dernier niveau de métal étant partiellement recouvert d'une couche de passivation formant une face supérieure de la partie d'interconnexion et possédant des ouvertures délimitant des plages de contact sur le dernier niveau de métal,
- une liaison électriquement conductrice entre une plage de contact et le substrat, et
- des moyens de séparation des blocs fonctionnels.

Selon cet aspect,
- la liaison électriquement conductrice comporte une première tranchée profonde s'étendant depuis ladite face supérieure de la partie d'interconnexion comportant ladite plage de contact jusqu'au substrat et dépourvue de ladite couche de passivation, et
- les moyens de séparation comportent une deuxième tranchée profonde située entre deux blocs fonctionnels adjacents, s'étendant entre les deux partie d'interconnexion associés à ces deux blocs fonctionnels jusqu'au substrat en traversant ledit au moins un matériau semiconducteur large bande, cette deuxième tranchée étant également dépourvue de couche de passivation.

La première tranchée et la deuxième tranchée sont également avantageusement dépourvues d'une couche métallique prolongeant le dernier niveau de métal.

Selon un mode de réalisation :
- la liaison électriquement conductrice comprend une couche électriquement conductrice (par exemple une couche de redistribution) tapissant le fond de la première tranchée au contact du substrat ainsi que la paroi latérale de cette première tranchée et s'étendant sur la face supérieure de la partie d'interconnexion jusqu'à ladite plage de contact, et
- les moyens de séparation une couche électriquement isolante, par exemple une couche de polyimide, située au-dessus de la paroi latérale et du fond de la deuxième tranchée.

Selon un mode de réalisation une partie du fond et de la paroi latérale de la deuxième tranchée est recouverte par une partie de la couche électriquement conductrice (par exemple une partie de la couche de redistribution) et cette partie de la couche électriquement conductrice ainsi que le reste du fond et de la paroi latérale de cette deuxième tranchée sont recouverts par la couche électriquement isolante (par exemple la couche de polyimide), cette couche électriquement isolante recouvrant également le reste de la couche électriquement conductrice à l'exception des zones situées au-dessus des plages de contact.

Selon un mode de réalisation, le circuit intégré comprend en outre des billes de connexion au-dessus des portions de la couche électriquement conductrice situées au-dessus des plages de contact.

Ledit au moins un matériau semiconducteur large bande est par exemple choisi dans le groupe formé par le nitrure de gallium et ses alliages et le carbure de silicium et ses alliages.

Selon un autre aspect il est proposé un dispositif intégré d'alimentation à découpage comportant le circuit intégré tel que défini ci-avant.

D'autres avantages et caractéristiques de l'invention apparaîtront à l'examen de la description détaillée de modes de mise en œuvre et de réalisation, nullement limitatifs, et des dessins annexés sur lesquels :

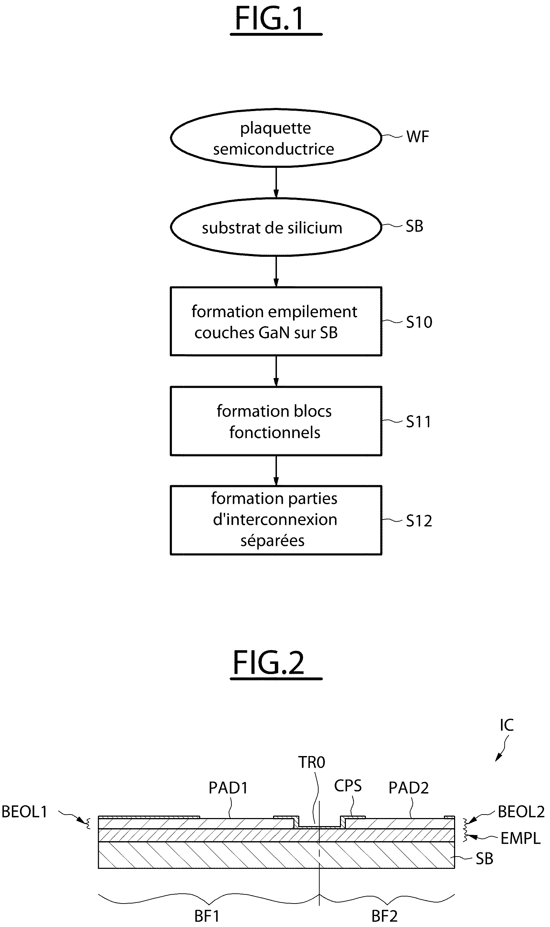

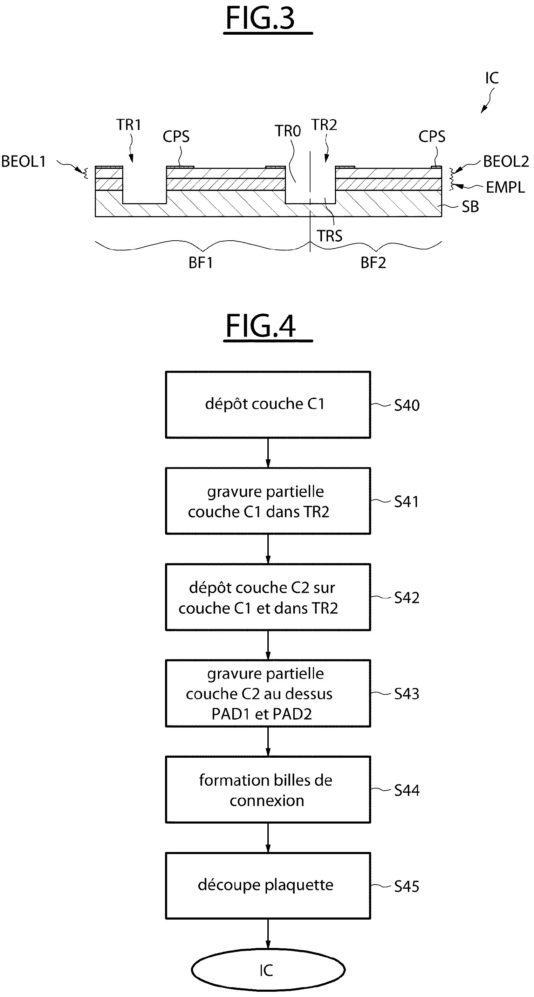

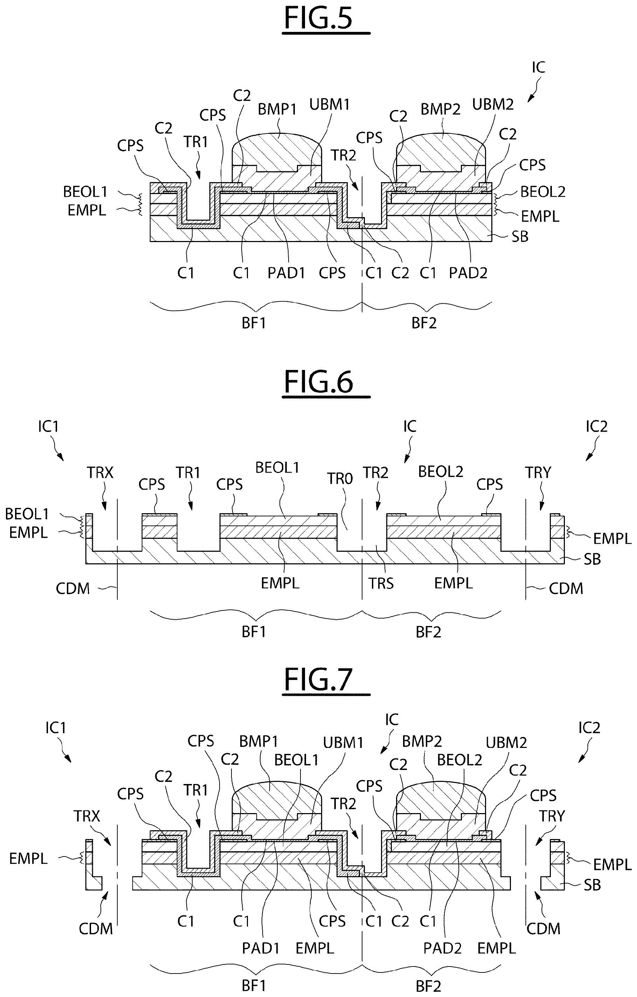

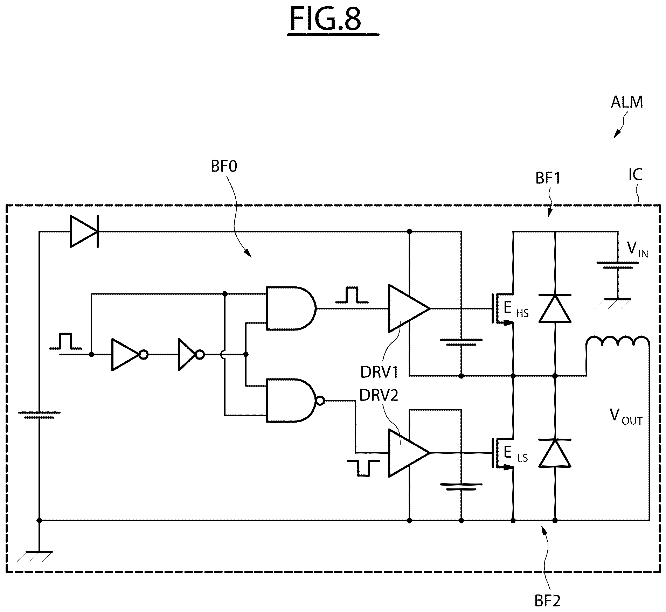

[Fig.1], [Fig.2], [Fig.3], [Fig.4], [Fig.5], [Fig.6], [Fig.7], et [Fig.8] illustrent des modes de mise en œuvre et de réalisation de l'invention.

**La** **figure 1** illustre des étapes d'une première phase d'un procédé de fabrication d'un circuit intégré selon l'invention.

Comme il est bien connu de l'homme du métier, plusieurs circuits intégrés identiques sont fabriqués simultanément sur une plaquette semiconductrice (« *wafer* »).

La plaquette comporte des lignes de découpe définissant des emplacements sur lesquels seront réalisés simultanément les circuits intégrés identiques. Puis, ceuxci seront après fabrication, individualisés par sciage de la plaquette le long des lignes de découpe.

Dans la suite du texte, à des fins de simplification, on ne décrira que la fabrication d'un seul de ces circuits intégrés.

Sur la plaquette semiconductrice WF comportant un substrat SB de silicium, par exemple un substrat dopé P, on forme, dans une étape S10, un empilement de couches d'un matériau semiconducteur à large bande interdite et de ses alliages, en l'espèce un empilement de couches de nitrure de gallium GaN et de ses alliages.

Plus précisément, après avoir déposé une couche de nitrure d'aluminium (AIN) sur la face supérieure du substrat SB, on dépose plusieurs couches d'un alliage de nitrure d'aluminium gallium (AlGaN).

Puis, on recouvre ces couches de AlGaN par une couche de nitrure de gallium (GaN), elle-même recouverte d'une autre couche mince de AlGaN.

Dans l'étape S11, on forme de façon classique et connue les différents blocs fonctionnels du circuit intégré.

A titre d'exemple non limitatif, et comme illustré très schématiquement sur la figure 8, le circuit intégré IC peut être destiné à incorporer une alimentation à découpage ALM.

Dans ce cas, les différents blocs fonctionnels peuvent comporter un bloc BF1 contenant un transistor HEMT HS référencé E_{HS}, un bloc BF2 contenant un transistor HEMT LS référencé E_{LS} ainsi qu'un bloc fonctionnel BF0 incorporant des pilotes DRV1 et DRV2.

Puis dans l'étape S12, on forme au-dessus de chaque bloc fonctionnel une partie d'interconnexion, ces parties d'interconnexion étant mutuellement séparées.

A l'issue de cette première phase du procédé de fabrication, on obtient le circuit intégré IC illustré schématiquement sur la figure 2.

Sur cette **figure 2****,** on a représenté à des fins de simplification uniquement deux blocs fonctionnels BF1 et BF2.

La référence SB désigne le substrat de silicium.

Ce substrat de silicium est surmonté de l'empilement EMPL, mentionné ci-avant, de couches du type GaN, au-dessus et au sein duquel sont formés les différents composants des blocs fonctionnels.

A des fins de simplification de la figure, ces différents composants ne sont pas représentés sur la figure 2.

A cet égard, la référence EMPL désigne globalement l'empilement des couches du type GaN ainsi que les différents composants des blocs fonctionnels.

La partie supérieure de la figure 2 illustre très schématiquement la partie d'interconnexion BEOL1 associée au bloc fonctionnel BF1 et la partie d'interconnexion BEOL2 associée au bloc fonctionnel BF2.

On voit que ces deux parties d'interconnexion BEOL1 et BEOL2 sont séparées par une tranchée initiale TR0.

En outre, une couche de passivation CPS, par exemple en nitrure de silicium, recouvre le dernier niveau de métal de la partie d'interconnexion BEOL1, le dernier niveau de métal de la partie d'interconnexion BEOL2 et tapisse les parois (parois latérales et paroi de fond) de la tranchée initiale TR0.

Cette couche CPS comporte des ouvertures délimitant des plages de contact (« Pads » en anglais) sur le dernier niveau de métal de chaque partie d'interconnexion.

A des fins de simplification de la figure, seule une plage de contact PAD1 est représentée sur la figure 2 pour la partie d'interconnexion BEOL1, et seule une plage de contact PAD2 est représentée pour la partie d'interconnexion BEOL2.

Comme illustré sur la **figure 3****,** on réalise dans le circuit intégré IC de la figure 2, une première tranchée profonde TR1 s'étendant depuis la face supérieure de la partie d'interconnexion BEOL1 jusqu'au substrat SB.

De même, on prolonge la tranchée initiale TR0 par une tranchée supplémentaire TRS de façon à atteindre également le substrat SB et former ainsi une deuxième tranchée profonde TR2.

Ces tranchées sont réalisées par tout moyen connu de l'homme du métier, par exemple avantageusement par découpe laser (« *laser dicing* ») ou découpe par plasma (« *plasma dicing* »).

La découpe laser, aussi appelée « rainure laser » (« *laser groove* »), est l'ablation par laser des couches du type GaN de l'empilement EMPL.

Comme on le verra plus en détail ci-après, la première tranchée profonde TR1 va contribuer à permettre une polarisation du substrat SB par le haut du circuit intégré tandis que la deuxième tranchée profonde TR2 va contribuer à la séparation physique des blocs fonctionnels BF1 et BF2.

On notera d'ores et déjà que comme les tranchées TR1 et TR2 sont formées à ce stade du procédé, ces tranchées TR1 et TR2 sont dépourvues sur leur paroi, de couches de passivation CPS ainsi que de couches métalliques issues du dernier niveau de métal des parties d'interconnexion BEOL1 et BEOL2, et ce contrairement aux procédés de l'art antérieur qui conduisait à la présence dans de telles tranchées d'un reliquat de couches de passivation et de métal provenant du dernier niveau de métallisation des parties d'interconnexion.

On se réfère maintenant plus particulièrement aux figures 4 et 5 pour décrire une deuxième phase du procédé de fabrication du circuit intégré.

Dans l'étape S40 **(****figure 4****)** on dépose sur toute la surface de la plaquette et par conséquent dans les tranchées TR1 et TR2, une couche électriquement conductrice C1 (figure 5), par exemple une couche de redistribution connue par l'homme du métier sous l'acronyme anglosaxon RDL (« *ReDistribution Layer* »).

Puis, comme illustré sur la **figure 5****,** on procède dans l'étape S41 à une gravure partielle de la couche C1 dans la deuxième tranchée TR2 de façon à découvrir une partie du fond de la deuxième tranchée TR2 ainsi qu'une partie de la paroi latérale de cette deuxième tranchée TR2, en l'espèce la paroi latérale adjacente au deuxième bloc fonctionnel BF2.

Puis, dans l'étape S42, on dépose une couche C2 électriquement isolante sur la couche C1 et sur les parties découvertes du fond et de la paroi latérale de la deuxième tranchée TR2.

Cette couche isolante C2 est par exemple une couche de polyimide.

Puis, dans l'étape S43, on effectue une gravure partielle de cette couche C2 au-dessus des plages de contact PAD1 et PAD2 (figure 5).

A ce stade, les plages de contact PAD1 et PAD2 sont recouvertes par une partie de la couche de redistribution C1.

On procède ensuite dans l'étape S44 à la formation de billes de connexion sur les plages de contact.

Sur la figure 5, deux billes de connexion BMP1 et BMP2 sont représentées.

Pour réaliser ces billes de connexion, on peut former au-dessus de la couche de redistribution C1, une couche métallique UBM1, UBM2, connue par l'homme du métier sous l'acronyme anglosaxon UBM (« *Under Ball Metal* »).

Ces couches métalliques UBM1 et UBM2 sont donc situées sous les billes de connexion BMP1 et BMP2.

On notera également que, comme illustré sur la figure 5, ont également été enlevées des parties de la couche C1 situées autour de la première tranchée TR1 (sauf la partie conduisant à la couche métallique UBM1), et autour de la couche métallique UBM2, de façon à n'avoir le contact avec le substrat SB que dans des zones d'intérêt pour ne pas court-circuiter toute la surface de la puce.

L'étape S45 est une étape de découpe de la plaquette le long des lignes de découpe, pour individualiser les circuits intégrés.

Après individualisation des circuits intégrés, on obtient le circuit intégré IC illustré sur la figure 5.

On voit sur cette figure 5 que le substrat SB peut être polarisé par l'intermédiaire de la bille de connexion BMP1 et de la couche de redistribution C1 qui est au contact du substrat SB dans le fond de la première tranchée profonde TR1.

Par ailleurs, les deux blocs fonctionnels BF1 et BF2 sont physiquement et électriquement séparés par l'intermédiaire de la couche isolante C2 qui tapisse la deuxième tranchée profonde TR2.

Le procédé qui vient d'être décrit permet une simplification de la première phase de fabrication illustrée sur la figure 1 et une industrialisation flexible à un coût plus faible notamment par l'utilisation d'un laser pour former les tranchées TR1 et TR2. En outre, on obtient une meilleure performance du dispositif électronique final en raison notamment du placement flexible de la première tranchée TR1 utilisée pour la polarisation du substrat SB.

Bien entendu, d'autres matériaux à large bande interdite sont possibles, comme par exemple du carbure de silicium (SiC) et ses alliages.

L'invention n'est pas limitée aux modes de mise en oeuvre et de réalisation qui viennent d'être décrits mais en embrasse toutes les variantes.

Une variante particulièrement avantageuse concerne plus particulièrement l'individualisation des circuits intégrés de la plaquette et va maintenant être décrite en se référant plus particulièrement aux figures 6 et 7.

Préalablement au sciage classique le long des lignes de découpe, il est recommandé de procéder au retrait par laser ou par gravure au plasma des couches du type GaN ou SiC de l'empilement le long de ces lignes de découpe afin d'éviter des fissures dans les circuits intégrés.

Ainsi, comme illustré sur la figure 6 qui montre le circuit intégré IC de la figure 3 encadré par deux autres circuits intégrés IC1 et IC2 de la plaquette, ce retrait peut avantageusement s'effectuer simultanément à la réalisation des tranchées TR1 et TR2, ce qui permet de ne pas réaliser d'étape supplémentaire spécifique ultérieure dans le procédé et offre ainsi un avantage industriel supplémentaire par rapport à ceux déjà mentionnés ci-avant.

Plus précisément, simultanément à la réalisation des tranchées TR1 et TR2, on réalise le long des lignes ou chemins de découpe CDM séparant les circuits intégrés IC1, IC, IC2, des tranchées de séparation TRX et TRY s'étendant jusqu'au substrat SB en traversant ledit empilement, ce qui permet de retirer les couches du type GaN ou SiC de l'empilement entre les circuits intégrés.

Puis comme illustré sur la figure 7, on procède pour l'individualisation des circuits intégrés IC, IC1 et IC2 à un sciage classique mécanique de la plaquette le long des lignes ou chemins de découpe CDM.

Comme indiqué ci-avant, les dispositifs électroniques intégrés sur un circuit intégré IC du type de celui qui vient d'être décrit peuvent être de différents types.

On peut en particulier obtenir une alimentation à découpage ALM (figure 8) dont le schéma classique est illustré sur la figure 8.

Plus précisément, à partir d'une tension d'entrée V_{IN}, on obtient une tension de sortie V_{OUT} en utilisant des transistors « côté haut » référencés E_{HS} et « côté bas » référencés E_{LS} connectés de façon classique à une inductance et pilotés par des circuits de pilotage ou pilotes DRV1 et DRV2 eux-mêmes commandés à partir d'une modulation par largeur d'impulsion (PWM).

## Revendications

1. Procédé de fabrication d'un circuit intégré monolithique, comprenant :
- une réalisation (S11) de blocs fonctionnels (BF1, BF2) au sein et au-dessus d'au moins un matériau semiconducteur large bande disposé sur un substrat de silicium,
- une réalisation (S12) de parties d'interconnexion (BEOL1, BEOL2) mutuellement séparées au-dessus des blocs fonctionnels,
- une séparation des blocs fonctionnels, et
- une réalisation d'une liaison électriquement conductrice entre le substrat (SB) et une plage de contact située sur une face supérieure de la partie d'interconnexion associée à un bloc fonctionnel,
- dans lequel la séparation des blocs fonctionnels et la réalisation de ladite liaison électriquement conductrice sont effectuées après la réalisation des parties d'interconnexion mutuellement séparées ;
- dans lequel ladite réalisation de la liaison électriquement conductrice comprend :
▪ une réalisation d'une première tranchée profonde (TR1) située à côté de ladite plage de contact (PAD1) et s'étendant depuis la face supérieure de ladite partie d'interconnexion (BEOL1) jusqu'au substrat,
▪ une formation d'une couche électriquement conductrice (C1) tapissant le fond de la première tranchée au contact du substrat ainsi que la paroi latérale de cette première tranchée et s'étendant sur la face supérieure de ladite partie d'interconnexion jusqu'à ladite plage de contact ; et
- dans lequel la réalisation de deux parties d'interconnexion séparées (BEOL1, BEOL2) au-dessus de deux blocs fonctionnels adjacents comporte une réalisation d'une tranchée initiale (TR0) entre les deux parties d'interconnexion, et ladite séparation comporte :
▪ une réalisation d'une tranchée supplémentaire (TRS) située entre les deux blocs fonctionnels adjacents, prolongeant ladite tranchée initiale et s'étendant jusqu'au substrat en traversant ledit au moins un matériau semiconducteur large bande, la tranchée initiale et la tranchée supplémentaire formant une deuxième tranchée profonde (TR2), et
▪ une formation d'une couche électriquement isolante (C2) située au-dessus de la paroi latérale et du fond de la deuxième tranchée (TR2).

2. Procédé selon la revendication 1, dans lequel :
- la couche électriquement conductrice (C1) est formée sur les parois de la première tranchée et de la deuxième tranchée et sur la face supérieure des deux parties d'interconnexion, puis
- une première partie de cette couche électriquement conductrice (C1) est retirée de la deuxième tranchée (TR2) de façon à découvrir une partie du fond et de la paroi latérale de cette deuxième tranchée et à laisser subsister une deuxième partie de la couche électriquement conductrice (C1) sur le reste du fond et de la paroi latérale de cette deuxième tranchée, puis
- la couche électriquement isolante (C2) est formée de façon à recouvrir la couche électriquement conductrice à l'exception des zones situées au-dessus des plages de contact et à recouvrir la partie découverte du fond et de la paroi latérale de la deuxième tranchée (TR2).

3. Procédé selon la revendication 2, comprenant en outre une formation de billes de connexion (BMP1, BMP2) au-dessus des portions de la couche électriquement conductrice situées au-dessus des plages de contact.

4. Procédé selon l'une des revendications précédentes, dans lequel le circuit intégré (IC) est fabriqué simultanément à d'autres circuits intégrés (IC1, IC2) sur une plaquette semiconductrice (WF) au sein d'emplacements séparés par des lignes de découpe (CDM) et préalablement au sciage de la plaquette le long des lignes de découpe, on réalise le long de ces lignes de découpes et simultanément à la réalisation des première (TR1) et deuxième (TR2) tranchées, des tranchées de séparation (TRX, TRY) s'étendant jusqu'au substrat en traversant ledit au moins un matériau semiconducteur large bande.

5. Procédé selon l'une des revendications précédentes, dans lequel ledit au moins un matériau semiconducteur large bande est choisi dans le groupe formé par le nitrure de gallium et ses alliages et le carbure de silicium et ses alliages.

6. Circuit intégré monolithique, comprenant :
- plusieurs blocs fonctionnels (BF1, BF2) au sein et au-dessus d'au moins un matériau semiconducteur large bande disposé sur un substrat de silicium (SB),
- une partie d'interconnexion (BEOL1, BEOL2) au-dessus de chaque bloc fonctionnel, comportant plusieurs niveau de métal, le dernier niveau de métal étant partiellement recouvert d'une couche de passivation (CPS) formant une face supérieure de la partie d'interconnexion et possédant des ouvertures délimitant des plages de contact sur le dernier niveau de métal,
- une liaison électriquement conductrice (C1) entre une plage de contact (PAD1) et le substrat, et
- des moyens de séparation des blocs fonctionnels,
- dans lequel :
- la liaison électriquement conductrice comporte une première tranchée profonde (TR1) s'étendant depuis ladite face supérieure de la partie d'interconnexion (BEOL1) jusqu'au substrat et dépourvue de ladite couche de passivation, et
- les moyens de séparation comportent une deuxième tranchée profonde (TR2) située entre deux blocs fonctionnels adjacents (BF1, BF2), s'étendant entre les deux parties d'interconnexion (BEOL1, BEOL2) associées à ces deux blocs fonctionnels jusqu'au substrat en traversant ledit au moins un matériau semiconducteur large bande, cette deuxième tranchée étant également dépourvue de couche de passivation.

7. Circuit intégré selon la revendication 6, dans lequel la première tranchée (TR1) et la deuxième tranchée (TR2) sont dépourvues d'une couche métallique prolongeant le dernier niveau de métal.

8. Circuit intégré selon la revendication 6 ou 7, dans lequel :
- la liaison électriquement conductrice comprend une couche électriquement conductrice (C1) tapissant le fond de la première tranchée au contact du substrat ainsi que la paroi latérale de cette première tranchée et s'étendant sur la face supérieure de la partie d'interconnexion jusqu'à ladite plage de contact, et
- les moyens de séparation comportent une couche électriquement isolante (C2) située au-dessus de la paroi latérale et du fond de la deuxième tranchée.

9. Circuit intégré selon la revendication 8, dans lequel une partie du fond et de la paroi latérale de la deuxième tranchée (TR2) est recouverte par une partie de la couche électriquement conductrice (C1) et cette partie de la couche électriquement conductrice ainsi que le reste du fond et de la paroi latérale de cette deuxième tranchée sont recouverts par la couche électriquement isolante (C2), cette couche électriquement isolante recouvrant également le reste de la couche électriquement conductrice à l'exception des zones situées au-dessus des plages de contact.

10. Circuit intégré selon la revendication 9, comprenant en outre des billes de connexion (BMP1, BMP2) au-dessus des portions de la couche électriquement conductrice (C1) situées au-dessus des plages de contact (PAD1, PAD2).

11. Circuit intégré selon l'une quelconque des revendications 6 à 10, dans lequel ledit au moins un matériau semiconducteur large bande est choisi dans le groupe formé par le nitrure de gallium et ses alliages et le carbure de silicium et ses alliages.

12. Dispositif intégré d'alimentation à découpage, comportant un circuit intégré (IC) selon l'une quelconque des revendications 6 à 11.
